# EUROPEAN PATENT APPLICATION

(11) **EP 4 651 321 A1**
(43) Date of publication of application: **19.11.2025**
(21) Application number: 24210528.6
(22) Date of filing: 04.11.2024
(51) Int. Cl.: H02B 1/56, H05K 7/20

(54) **ELECTRICAL CABINET AND PHOTOVOLTAIC POWER GENERATION SYSTEM**

(30) Priority: 17.05.2024 CN 202421106173 U
(71) Applicant: Sungrow Power Supply Co., Ltd., Hefei, Anhui 230088 (CN)
(72) Inventor: ZHANG, Yayun, Hefei, 230088 (CN); PAN, Hanfei, Hefei, 230088 (CN); ZHANG, Xianwei, Hefei, 230088 (CN)
(74) Representative: Rooney, John-Paul

(57) **Abstract**

An electrical cabinet and a photovoltaic power generation system are provided. The electrical cabinet includes a cabinet body (1) and a heat exchanger (2). The cabinet body (1) is provided with a first switch area (16) and a second switch area (19). The first switch area (16) and the second switch area (19) are distributed on opposite sides of the cabinet body (1) along a first direction. At least one of the first switch area (16) and the second switch area (19) is provided with a switch (3). The first switch area (16) and the second switch area (19) are both located in a heat dissipation air duct of the cabinet body (1) and are distributed along an airflow direction in the heat dissipation air duct. The heat exchanger (2) can exchange heat with the heat dissipation air duct. According to the electrical cabinet, the heat dissipation air duct is simplified and the heat dissipation effect is also improved, thereby improving the heat dissipation capacity of the electrical cabinet.

## Description

### FIELD OF THE INVENTION

The present application relates to the technical field of photovoltaic power generation and, more particularly, to an electrical cabinet and a photovoltaic power generation system.

### BACKGROUND

In photovoltaic power generation systems, an electrical cabinet (a low-voltage combiner cabinet) serves as mid-end equipment between an inverter and a transformer.

An electrical cabinet mainly includes a switch and a circuit breaker. The switch is connected to an alternating current (AC) output terminal of an inverter, and then connected to the circuit breaker to realize the convergence of low-voltage AC power. With the increasing demand for inverters, the structural design requirements for electrical cabinets are becoming higher and higher. The conventional electrical cabinets have difficulty in meeting the requirements of heat dissipation capacity and maintainability, and in meeting the demands of different power levels.

### SUMMARY

In view of this, the object of the present application is to provide an electrical cabinet and a photovoltaic power generation system to improve the heat dissipation capacity of the electrical cabinet.

In order to achieve the object, the present application provides the following technical solutions.

An electrical cabinet includes a cabinet body and a heat exchanger; wherein
the cabinet body is provided with a first switch area and a second switch area, the first switch area and the second switch area are distributed on opposite sides of the cabinet body and distributed in sequence along a first direction, and at least one of the first switch area and the second switch area is provided with a switch; and
the first and second switch areas are both located in a heat dissipation air duct of the cabinet body, and are distributed along an airflow direction in the heat dissipation air duct; and the heat exchanger is configured to exchange heat with the heat dissipation air duct.

In an embodiment, an airflow in the heat dissipation air duct flows through the first switch area and the second switch area in the first direction.

In an embodiment, the heat exchanger includes first and second heat exchange channels that are capable of heat exchange, and the heat dissipation air duct and the second heat exchange channel are connected end to end to form an inner circulation air duct.

In an embodiment, the heat dissipation air duct includes first to third heat dissipation air ducts that are sequentially communicated; wherein
the first and third heat dissipation air ducts are arranged side by side, and the second heat dissipation air duct and the second heat exchange channel are arranged side by side;
an inlet of one of the first and third heat dissipation air ducts is a heat dissipation inlet of the heat dissipation air duct, and an outlet of the other of the first and third heat dissipation air ducts is a heat dissipation outlet of the heat dissipation air duct; and
the first and second switch areas are both located in the first heat dissipation air duct.

In an embodiment, a first cabinet door is provided on a side of the cabinet body having the first switch area, and a second cabinet door is provided on a side of the cabinet body having the second switch area; and the second heat dissipation air duct is provided on an inner side of the first cabinet door or the second cabinet door.

In an embodiment, the first heat dissipation air duct is lower than the third heat dissipation air duct, or the first heat dissipation air duct is higher than the third heat dissipation air duct; and/or
the first heat dissipation air duct is arranged in a horizontal direction, and the third heat dissipation air duct is arranged in the horizontal direction.

In an embodiment, the heat exchanger, the heat dissipation inlet, and the heat dissipation outlet are distributed on the same side of the cabinet body.

In an embodiment, a first cabinet door is provided on a side of the cabinet body having the first switch area, and a second cabinet door is provided on a side of the cabinet body having the second switch area; and the heat exchanger is provided on the first cabinet door or the second cabinet door.

In an embodiment, the electrical cabinet further includes a first fan which is arranged at a communication position of the first heat dissipation air duct and the second heat dissipation air duct, the first fan is configured to drive the airflow to flow from the first heat dissipation air duct to the second heat dissipation air duct, or flow from the second heat dissipation air duct to the first heat dissipation air duct; and/or
the heat exchanger further includes a second fan which is arranged at a communication position of the third heat dissipation air duct and the second heat exchange channel, the second fan is configured to drive the airflow to flow from the third heat dissipation air duct to the second heat exchange channel, or flow from the second heat exchange channel to the third heat dissipation air duct.

In an embodiment, a first cabinet door is provided on a side of the cabinet body having the first switch area, and a second cabinet door is provided on a side of the cabinet body having the second switch area;
one of the first fan and the second fan is arranged on the first cabinet door, and the other of the first fan and the second fan is arranged on the second cabinet door.

In an embodiment, an inlet and an outlet of the first heat exchange channel are both in communication with the external environment of the cabinet; and the heat exchanger further includes a third fan which is configured to drive air from the external environment to flow through the first heat exchange channel; and/or
a heat dissipation inlet and a heat dissipation outlet of the heat dissipation air duct, and the heat exchanger are arranged on the same side of the cabinet body; and/or
the heat dissipation inlet faces the first switch area or the second switch area.

In an embodiment, switches in at least one of the first and second switch areas are arranged in a row along a second direction perpendicular to the first direction.

In an embodiment, the cabinet body is further provided with a circuit breaker area and a power distribution area. The circuit breaker area and the first switch area are located on the same side of the cabinet body, and the power distribution area and the second switch area are located on the same side of the cabinet body. The circuit breaker area and the power distribution area are both located in the heat dissipation air duct.

In an embodiment, the first switch area, the second switch area, the power distribution area, and the circuit breaker area are sequentially distributed along the airflow direction; or, the circuit breaker area, the power distribution area, the second switch area, and the first switch area are sequentially distributed along the airflow direction.

In an embodiment, the cabinet body is further provided with a first wiring area and a second wiring area. The first wiring area and the first switch area are located on the same side of the cabinet body and are adjacent to each other; and the second wiring area and the second switch area are located on the same side of the cabinet body and are adjacent to each other.

In an embodiment, a first cabinet door is provided on a side of the cabinet body having the first switch area, and a second cabinet door is provided on a side of the cabinet body having the second switch area, and a tray is provided in the cabinet body and is located on an inner side of at least one of the first cabinet door and the second cabinet door; wherein
the tray is configured to mount thereon a first device; in a case that a cabinet door corresponding to the tray is opened, the first device is exposed from the cabinet body to enable the first device to be maintainable; and/or
a second device is provided in the cabinet body and is located on an inner side of the tray, and the tray is movably arranged in the cabinet body; in a case that the cabinet door corresponding to the tray is opened and the tray is moved to a predetermined position, the second device is exposed from the cabinet body to enable maintenance of the second device.

In an embodiment, the tray is rotatably arranged in the cabinet body; and/or
the second device at least includes a fourth fan which is configured to drive the airflow in the heat dissipation air duct to flow through a heating device other than the switch.

In an embodiment, the heating device other than the switch is a circuit breaker.

Based on the electrical cabinet described above, a photovoltaic power generation system is also provided according to the present application, which includes the electrical cabinet as described above.

The heat dissipation principle of the electrical cabinet according to the present application is as follows: since the first switch area and the second switch area are both located in the heat dissipation air duct of the cabinet body and are distributed along the airflow direction in the heat dissipation air duct, the airflow in the heat dissipation air duct flows through the switches in the first switch area and the second switch area, thereby achieving heat dissipation of the switches; the heat exchanger can exchange heat with the heat dissipation air duct, so that the heat exchanger can cool the airflow flowing through the heat dissipation air duct, thereby ensuring the heat dissipation effect of the switches.

In the electrical cabinet according to the present application, since the first and second switch areas are distributed on opposite sides of the cabinet body and are distributed sequentially along the first direction, at least one of the first switch area and the second switch area is provided with the switch. In this way, it is ensured that the heat dissipation airflow flows through the first switch area and the second switch area in sequence, or the heat dissipation airflow flows through the second switch area and the first switch area in sequence. Compared with the conventional technology, the heat dissipation air duct is simplified and the heat dissipation effect is improved, thereby improving heat dissipation capacity of the electrical cabinet and meeting the high requirements for the heat dissipation capacity.

Moreover, in the electrical cabinet according to the present application, the airflow in the heat dissipation air duct flows through the first and second switch areas in the first direction, improving the heat dissipation uniformity of the first and second switch areas, and also improving the heat dissipation effect, so that the heat dissipation capacity of the electrical cabinet is improved and the high requirements for the heat dissipation capacity is met.

### BRIEF DESCRIPTION OF THE DRAWING

In order to more clearly illustrate the technical solutions in the embodiments of the present application or in the conventional technology, the drawings required in the description of the embodiments or the conventional technology are briefly introduced below. Apparently, the drawings in the following description are only the embodiments of the present application, and for those skilled in the art, other drawings may also be obtained based on the provided drawings without creative efforts.
FIG. 1 is an axonometric view of an electrical cabinet according to an embodiment of the present application;
FIG. 2 is an axonometric view of an electrical cabinet according to an embodiment of the present application of the application, with a first cabinet door and a second cabinet door of the electrical cabinet being opened;
FIG. 3 is a schematic view showing an internal structure and heat dissipation of an electrical cabinet according to an embodiment of the present application;
FIG. 4 is a schematic view showing heat dissipation of an electrical cabinet according to an embodiment of the present application;
FIG. 5 is a schematic view showing an internal structure on a first side of an electrical cabinet according to an embodiment of the present application;
FIG. 6 is a schematic view showing an internal structure on a second side of an electrical cabinet according to an embodiment of the present application; and
FIG. 7 is a schematic structural view of an electrical cabinet provided with a tray on a second side according to an embodiment of the present application.

Reference signs in the FIG. s are listed as follows:
1 - cabinet body, 11 - first cabinet door, 12 - second cabinet door, 13 - first side, 14 - second side, 15 - circuit breaker area, 16 - first switch area, 17 - first wiring area, 18 - power distribution area, 19 - second switch area, 110 - second wiring area, 1a - first heat dissipation air duct, 1b - second heat dissipation air duct, 1c - third heat dissipation air duct, 2 - heat exchanger, 21 - outer air inlet, 22 - outer air outlet, 23 - inner air inlet, 24 - inner air outlet, 2a - first heat exchange channel, 2b - second heat exchange channel, 3 - switch, 31 - load switch, 32 - fuse, 4 - first fan, 5 - second fan, 7 - third fan, 8 - fourth fan, 9 - tray.

### DETAIL DESCRIPTION OF EMBODIMENTS

The technical solutions in the embodiments of the present application are clearly and completely described below in conjunction with the drawings. Apparently, the described embodiments are only part of the embodiments of the present application, not all of the embodiments of the present application. Any other embodiment obtained by those skilled in the art based on the embodiments in the present application without creative efforts are within the protection scope of the present application.

The technical solutions in the embodiments of the present application are clearly and completely described below in conjunction with the drawings. The terms used in the embodiments are only for the purpose of describing specific embodiments, and are not intended as limitations to the present application. As used in the specification and appended claims of the present application, singular expressions "a", "an", "said", "the above", "the" and "this" are intended to also include expressions such as "one or more", unless there is a clear contrary indication in the context. It should also be understood that in the embodiments of the present application, "one or more" refers to one, two, or more; "and/or" describes association relationships of associated object, indicating that there may be three relationships, for example, A and/or B may indicate: A exists alone, A and B exist simultaneously, and B exists alone, where A and B may be singular or plural; the character "/" generally indicates that the associated objects before and after the character "/" are in an "or" relationship.

Reference to "an embodiment" or "some embodiments" described in the specification means that specific features, structures, or characteristic described in conjunction with the embodiment are included in one or more embodiments of the present application. Thus, the statements "in an embodiment", "in some embodiments", "in other embodiments", "in some other embodiments", etc. that appear in different places in the specification do not necessarily refer to the same embodiment, but mean reference to "one or more but not all embodiments", unless otherwise specifically emphasized in other ways. The terms "include", "comprise", "have" and their variations mean "include but not limited to", unless otherwise specifically emphasized in other ways.

Multiple involved in the embodiments of the present application indicates greater than or equal to two. It should be noted that in the description of the embodiments of the present application, words such as "first", "second" and the like are only used for the purpose of distinguishing the description, and cannot be understood as indicating or implying relative importance, nor can they be understood as indicating or implying order.

"Parallel" and "perpendicular" involved in the present application are "substantially parallel" and "substantially perpendicular" in actual operation. "Substantially parallel" can be understood as parallel with a certain error, and similarly, "substantially perpendicular" can be understood as perpendicular with a certain error.

An electrical cabinet according to the present application may be an alternating current (AC) electrical cabinet, e.g., a photovoltaic grid-connected low-voltage combiner cabinet, a low-voltage combiner cabinet, etc. The electrical cabinet may be an important component to connect an output of an inverter to an input of an AC distribution cabinet or a step-up transformer, and can collect the alternating current output by multiple inverters and then output the alternating current, greatly simplifying connection lines between the inverters and the AC distribution cabinet or the step-up transformer. The access of the electrical cabinet serves as an output disconnection point of the inverter, which can protect the inverter from harm from an AC power grid, improve the safety of the system, and protect the safety of installation and maintenance personnel.

An electrical cabinet is provided according to an embodiment of the present application, which simplifies the heat dissipation air duct and improves the heat dissipation effect, thereby improving the heat dissipation capacity of the electrical cabinet. It is convenient to meet high demand for heat dissipation capacity.

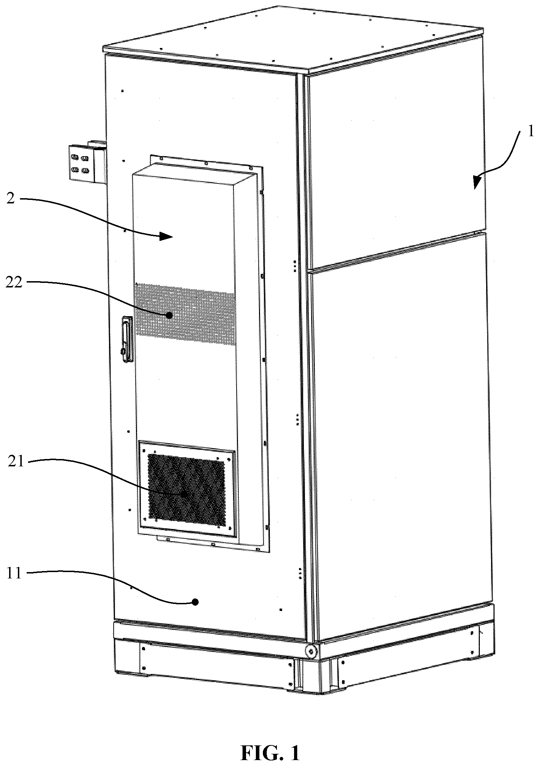

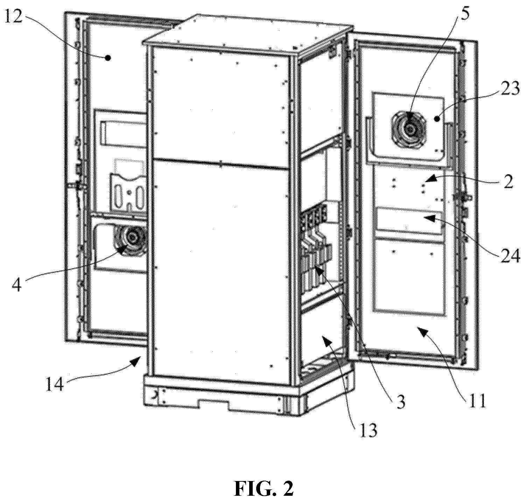

As shown in FIGs. 1 and 2, the electrical cabinet according to the embodiment of the present application includes a cabinet body 1 and a heat exchanger 2.

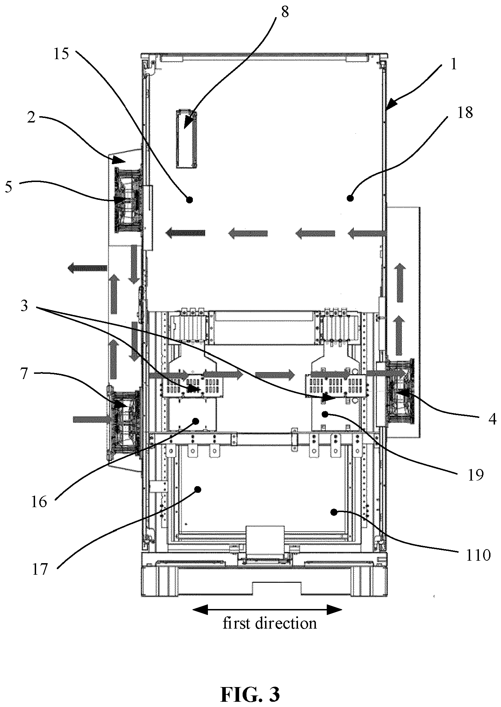

As shown in FIG. 3, the cabinet body 1 is provided with a first switch area 16 and a second switch area 19. The first switch area 16 and the second switch area 19 are distributed on opposite sides of the cabinet body 1 and sequentially along a first direction.

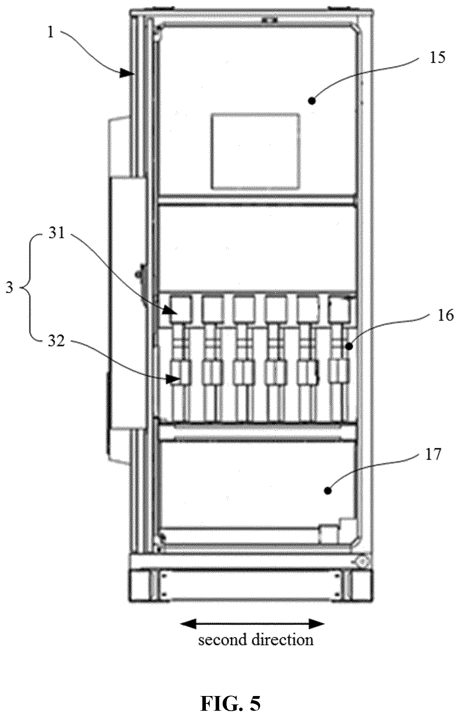

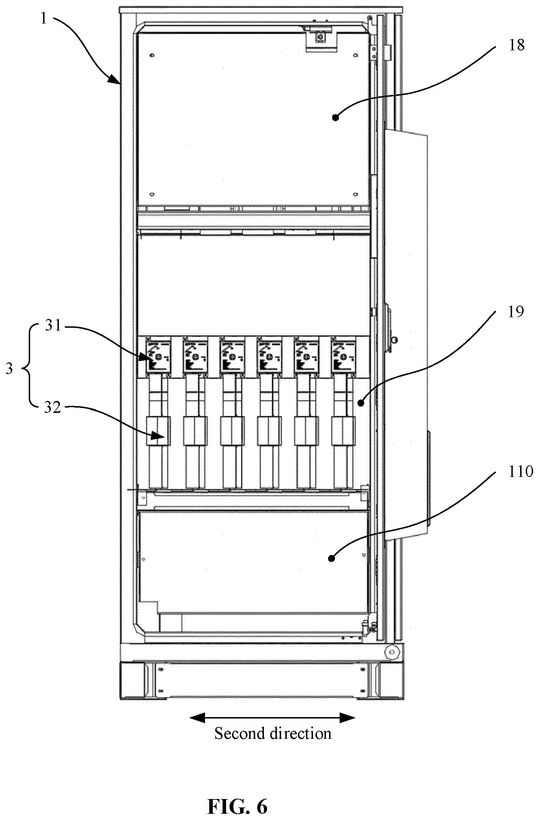

As shown in FIGs. 5 and 6, a switch 3 is provided at each of the first switch area 16 and the second switch area 19. Alternatively, a switch 3 is provided at only one of the first switch area 16 and the second switch area 19.

In a case that the switch 3 is provided in the first switch area 16, the number of the switch 3 in the first switch area 16 may be one or more, which is selected according to the actual situation and is not limited in the embodiment. In order to facilitate the arrangement of switches 3, the switches 3 in the first switch area 16 may be arranged in rows along a second direction perpendicular to the first direction. In the first switch area 16, the switches 3 may be arranged in one or more rows. The number of rows of the switches 3 is selected according to the actual situation, and is not limited in the embodiment.

In a case that the switch 3 is provided in the second switch area 19, the number of the switch 3 in the second switch area 19 may be one or more, which is selected according to the actual situation and is not limited in the embodiment. In order to facilitate the arrangement of switches 3, the switches 3 in the second switch area 19 may be arranged in rows along the second direction perpendicular to the first direction. In the second switch area 19, the switches 3 may be arranged in one or more rows. The number of rows of the switches 3 is selected according to the actual situation, and is not limited in the embodiment.

In practical situations, both the first and second directions may be perpendicular to a vertical direction. For example, the first direction is a length direction of the cabinet body 1, and the second direction is a width direction of the cabinet body 1. Alternatively, the first direction is the width direction of the cabinet body 1, and the second direction is the length direction of the cabinet body 1.

The first switch area 16 and the second switch area 19 may be sequentially distributed in other directions, which is not limited in the embodiment.

The number of the switches 3 in the first switch area 16 and the number of the switches 3 in the second switch area 19 may be the same or different, which may be selected according to the actual situation.

In a case that the number of the switches 3 in the first switch area 16 and the number of the switches 3 in the second switch area 19 are the same, the switches 3 in the first switch area 16 and the switches 3 in the second switch area 19 may be symmetrically distributed. For example, the switches 3 in the first switch area 16 are first switches, and the switches 3 in the second switch area 19 are second switches which are symmetrically distributed with respect to the first switches. In order to facilitate the operation of the switch 3, an operating surface of the first switches and an operating surface of the second switches face away from each other. It can be understood that the operating surface of the first switches is located on a side of the first switches away from the second switches, and the operating surface of the second switches is located on a side of the second switches away from the first switches.

In practical situations, the first switches and the second switches may also be distributed asymmetrically, which is not limited to the above embodiment.

As shown in FIGs. 5 and 6, the switches 3 includes a load switch 31 and a fuse 32. One end of the fuse 32 is electrically connected to an AC output side of the inverter, and the other end of the fuse 32 is electrically connected to the load switch 31. The switch 3 may be of other structures, which is not limited in the embodiment.

In the embodiment of the present application, the first switch area 16 and the second switch area 19 are both located in a heat dissipation air duct of the cabinet body 1, and are distributed along an airflow direction in the heat dissipation air duct.

For example, the first switch area 16 and the second switch area 19 are sequentially distributed along the airflow direction in the heat dissipation air duct, that is, a cold air flow flows firstly through the first switch area 16 and then through the second switch area 19. Alternatively, the second switch area 19 and the first switch area 16 are sequentially distributed along the airflow direction in the heat dissipation air duct, that is, the cold air flow flows firstly through the second switch area 19 and then through the first switch area 16.

In the embodiment of the present application, the heat exchanger 2 can exchange heat with the heat dissipation air duct. For example, the heat exchanger 2 communicates with the heat dissipation air duct and is configured to cool airflow passing through the heat dissipation air duct. The specific structure of the heat exchanger 2 may be selected according to the actual situation, which is not limited in the embodiment.

The heat dissipation principle of the electrical cabinet according to the above embodiment is as follows: since the first switch area 16 and the second switch area 19 are both located in the heat dissipation air duct of the cabinet body 1 and are distributed along the air flow direction in the heat dissipation air duct, the airflow in the heat dissipation air duct flows through the switches 3 in the first switch area 16 and the second switch area 19, thereby achieving heat dissipation of the switches 3. The heat exchanger 2 cools the airflow flowing through the heat dissipation air duct, ensuring the heat dissipation effect of the switches 3.

The above heat dissipation method adopts the heat dissipation design of heat exchange instead of the heat dissipation design of direct ventilation, improving the IP level of the electrical cabinet.

In the electrical cabinet according to the above embodiment, since the first switch area 16 and the second switch area 19 are distributed on opposite sides of the cabinet body 1 and are sequentially distributed along the first direction, and at least one of the first switch area 16 and the second switch area 19 is provided with the switch 3, it is ensured that the airflow in the heat dissipation air duct flows through the first switch area 16 and the second switch area 19 successively, or the airflow in the heat dissipation air duct flows through the second switch area 19 and the first switch area 16 successively. Compared with the conventional technology, the heat dissipation air duct is simplified and the heat dissipation effect is improved, thereby improving the heat dissipation capacity of the electrical cabinet and meeting the high demand for heat dissipation capacity.

In some embodiments, the airflow in the heat dissipation air duct flows through the first switch area 16 and the second switch area 19 in the first direction. In this way, the heat dissipation uniformity of the first switch area 16 and the second switch area 19 is improved, especially in the case that the switches 3 are distributed in rows along the second direction. Thus, the heat dissipation effect is effectively improved, thereby improving the heat dissipation capacity of the electrical cabinet and meeting the high demand for heat dissipation capacity.

For example, if the first direction is the length direction of the cabinet body 1, the airflow in the heat dissipation air duct flows through the first switch area 16 and the second switch area 19 along the length direction of the cabinet body 1. Alternatively, if the first direction is the width direction of the cabinet body 1, the airflow in the heat dissipation air duct flows through the first switch area 16 and the second switch area 19 along the width direction of the cabinet body 1.

It should be noted that the airflow in the heat dissipation air duct may flow firstly through the first switch area 16 and then flow through the second switch area 19, or may flow firstly through the second switch area 19 and then flow through the first switch area 16.

As shown in FIGs. 1 and 2, in order to facilitate operation and maintenance of the switches 3, a first cabinet door 11 is provided on a side of the cabinet body 1 having the first switch area 16, and a second cabinet door 12 is provided on a side of the cabinet body 1 having the second switch area 19. For example, a first side 13 and a second side 14 of the cabinet body 1 are arranged opposite to each other. The first switch area 16 and the first cabinet door 11 are both located on the first side 13 of the cabinet body 1, and the second switch area 19 and the second cabinet door 12 are both located on the second side 14 of the cabinet body 1.

Each of the first and second cabinet doors 11, 12 can open and close the cabinet body 1. In this way, the switch 3 in the first switch area 16 can be maintained by opening the first cabinet door 11, and the switch 3 in the second switch area 19 can be maintained by opening the second cabinet door 12. Thus, the maintainable operation surface of the electrical cabinet is increased and the maintainability of the electrical cabinet is effectively improved.

As mentioned above, the switches 3 in the first and second switch areas 16, 19 are arranged in rows along the second direction perpendicular to the first direction. In this way, it is convenient to increase or decrease the number of the switches 3, and the number of input paths of the switches 3 can be increased or decreased by increasing or decreasing the number of the switches 3, thereby achieving different whole machine powers and meeting the requirements of different power levels. Further, the power density of the entire machine is improved and the later maintenance time is shortened.

In order to facilitate opening and closing of the cabinet body 1, the first cabinet door 11 and the second cabinet door 12 may be rotatably arranged on the cabinet body 1. For example, each of the first cabinet door 11 and the second cabinet door 12 is rotatably arranged on the cabinet body 1 through a hinge.

In an embodiment of the present application, the cabinet body 1 may be provided with other cabinet doors. For example, a cabinet door is provided on a side of the cabinet body 1 other than the first and second sides 13, 14. The opening and closing manners of the cabinet doors may be selected according to the actual situation, which is not limited herein.

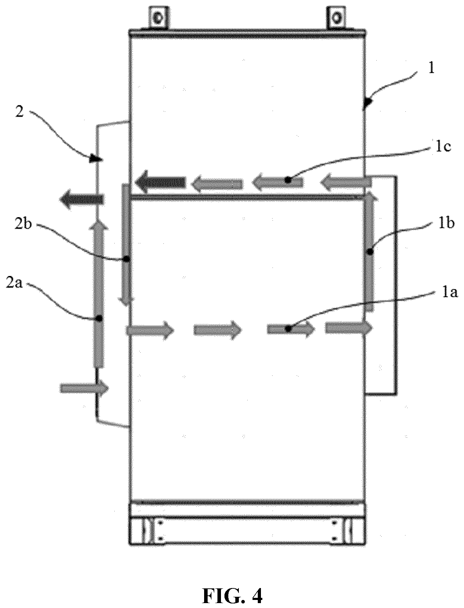

As shown in FIG. 4, in the embodiment of the present application, the heat exchanger 2 includes a first heat exchange channel 2a and a second heat exchange channel 2b that are provided for heat exchange. The heat dissipation air duct and the second heat exchange channel 2b communicate end to end to form an inner circulation air duct. The first heat exchange channel 2a is configured to cool the second heat exchange channel 2b.

It should be noted that a heat dissipation inlet and a heat dissipation outlet of the heat dissipation air duct are both in communication with the heat exchanger 2. The airflow cooled by the heat exchanger 2 enters the heat dissipation air duct via the heat dissipation inlet, and the hot airflow in the heat dissipation air duct flows to the heat exchanger 2 via the heat dissipation outlet.

In order to facilitate the formation of the inner circulation air duct, the heat dissipation air ducts include: a first heat dissipation air duct 1a, a second heat dissipation air duct 1b, and a third heat dissipation air duct 1c that are sequentially communicated. The first and third heat dissipation air ducts 1a, 1c are distributed in parallel, and the second heat dissipation air duct 1b and the second heat exchange channel 2b are distributed in parallel. An inlet of one of the first and third heat dissipation air ducts 1a, 1c is the heat dissipation inlet of the heat dissipation air duct, and an outlet of the other of the first and third heat dissipation air ducts 1a, 1c is the heat dissipation outlet of the heat dissipation air duct. The first and second switch areas 16, 19 are both located in the first heat dissipation air duct 1a. It should be noted that the first or second switch area 16, 19 is close to the second heat dissipation air duct 1b.

Since the switches 3 in the first and second switch areas 16, 19 generates a large amount of heat, the inlet of the first heat dissipation air duct 1a may serve as the heat dissipation inlet of the heat dissipation air duct, and the outlet of the third heat dissipation air duct 1c may be the heat dissipation outlet of the heat dissipation air duct. In this way, the cold air flow discharged from the heat exchanger 2 firstly flows through the first switch area 16 and the second switch area 19, improving the heat dissipation effect of the switches 3.

In order to facilitate the formation of the second heat dissipation air duct 1b, the second heat dissipation air duct 1b may be arranged on an inner side of the first cabinet door 11 or the second cabinet door 12. In this way, it is also convenient to maintain the second heat dissipation duct 1b.

In an aspect, in order to facilitate the flow of air in the inner circulation air duct, the first heat dissipation air duct 1a may be lower or higher than the third heat dissipation air duct 1c. Since the first switch area 16 and the second switch area 19 are both located in the first heat dissipation air duct 1a, in order to facilitate the operation of the switches 3, the first heat dissipation air duct 1a may be lower than the third heat dissipation air duct 1c.

In a case that the first heat dissipation air duct 1a is lower or higher than the third heat dissipation air duct 1c, the heat dissipation inlet and the heat dissipation outlet may be distributed in sequence along the vertical direction. The second heat dissipation air duct 1b and the second heat exchange channel 2b may be distributed in sequence along the first direction, the second heat dissipation air duct 1b and the second heat exchange channel 2b being each arranged in the vertical direction. In this way, the structure of the heat dissipation air duct is simplified.

In the other aspect, in order to facilitate the flow of the air in the inner circulation air duct, the first and third heat dissipation air ducts 1a, 1c may each be arranged in the horizontal direction. For example, the first and third heat dissipation air ducts 1a, 1c each is arranged in the first direction. In this way, the inner circulation air duct can be simplified.

The above two aspects can be carried out separately or simultaneously (combination of the above two aspects), which is selected according to the actual situation and is not limited in the embodiments. In a case that the two aspects are carried out simultaneously, the flow of the air in the inner circulation air duct is facilitated to the greatest extent, and the inner circulation air duct is simplified.

In order to simplify the structure and installation of the heat exchanger 2, the heat exchanger 2 and the heat dissipation inlet and outlet are distributed on the same side of the cabinet body 1. As shown in FIG. 2, the first and second sides 13, 14 of the cabinet body 1 are arranged opposite to each other. The first switch area 16 is located on the first side 13 of the cabinet body 1, and the second switch area is located on the second side 14 of the cabinet body 1. All of the heat exchanger 2, the heat dissipation inlet, and the heat dissipation outlet are distributed on the first side 13 or the second side 14 of the cabinet body 1. In this case, the heat exchanger 2 may be arranged on the first cabinet door 11 or the second cabinet door 12.

In a case that the heat exchanger 2 is arranged on the first cabinet door 11, the second heat exchange channel 2b may be arranged on the first cabinet door 11. Alternatively, in a case that the heat exchanger 2 is arranged on the second cabinet door 12, the second heat exchange channel 2b may be arranged on the second cabinet door 12.

The heat exchanger 2 may be located inside the cabinet body 1 or outside the cabinet body 1. In order to reduce the volume of the cabinet body 1, the heat exchanger 2 may be located outside the cabinet body 1.

As shown in FIGs. 3 and 4, in some embodiments, in order to ensure circulation of the airflow in the inner circulation air duct, the electrical cabinet further includes a first fan 4 and/or the heat exchanger 2 further includes a second fan 5. For example, the electrical cabinet further includes the first fan 4, or the heat exchanger 2 further includes the second fan 5; or the electrical cabinet further includes the first fan 4 and the heat exchanger 2 further includes the second fan 5.

The first fan 4 is arranged at a communication position of the first and second heat dissipation air ducts 1a and 1b. The first fan 4 is configured to drive the airflow to flow from the first heat dissipation air duct 1a to the second heat dissipation air duct 1b, or flow from the second heat dissipation air duct 1b to the first heat dissipation air duct 1a. The first fan 4 may be arranged in the first or second heat dissipation air duct 1a, 1b. In this way, it is convenient for the airflow to pass through the first and second heat dissipation air ducts 1a, 1b, thereby ensuring that the airflow circulates in the inner circulation air duct.

The second fan 5 is arranged at a communication position of the third heat dissipation air duct 1c and the second heat exchange channel 2b. The second fan 5 is configured to drive the airflow to flow from the third heat dissipation air duct 1c to the second heat exchange channel 2b, or flow from the second heat exchange channel 2b to the third heat dissipation air duct 1c. The second fan 5 is a part of the heat exchanger 2, and the second fan 5 may be arranged in the second heat exchange channel 2b. In this way, it is convenient for the airflow to pass through the third heat dissipation air duct 1c and the second heat exchange channel 2b, thereby ensuring that the airflow circulates in the inner circulation air duct.

In a case that the first and third heat dissipation air ducts 1a, 1c are distributed in sequence along the vertical direction (the first heat dissipation air duct 1a is lower or higher than the third heat dissipation air duct 1c), and the second heat dissipation air duct 1b and the second heat exchange channel 2b are distributed in sequence along the first direction, both the first and second fans 4, 5 may be centrifugal fans. Compared with a conventional electrical cabinet using an axial flow fan, since the air volume and pressure of the centrifugal fans are large, the amount of airflow in the heat dissipation air duct and thus the heat dissipation performance are effectively increased, and the heat dissipation cost can be reduced.

The first and second fans 4, 5 may be of other types, and are not limited to centrifugal fans.

In practical applications, a fan may be arranged at a communication position of the second and third heat dissipation air ducts 1b, 1c to drive the airflow to flow from the second heat dissipation air duct 1b to the third heat dissipation air duct 1c, or flow from the third heat dissipation air duct 1c to the second heat dissipation air duct 1b.

In order to facilitate the arrangement of the first fan 4 and the second fan 5, the first fan 4 may be arranged in the second heat dissipation air duct 1b. In this case, one of the first fan 4 and the second fan 5 is arranged on the first cabinet door 11, and the other of the first fan 4 and the second fan 5 is arranged on the second cabinet door 12. In this way, it is convenient to mount and maintain the first fan 4 and the second fan 5. It should be noted that, in the case that the second fan 5 is arranged on the first cabinet door 11, it indicates that the heat exchanger 2 is arranged on the first cabinet door 11; in the case that the second fan 5 is arranged on the second cabinet door 12, it indicates that the heat exchanger 2 is arranged on the second cabinet door 12.

In the heat exchanger 2, gas or liquid may flow through the first heat exchange channel 2a, which may be selected according to the actual situation. In order to reduce the heat dissipation cost, an inlet and an outlet of the first heat exchange channel 2a are both in communication with the external environment of the cabinet body 1, that is, the first heat exchange channel 2a is configured to be in communication with the external environment of the electrical cabinet. As shown in FIGs. 3 and 4, in order to improve heat exchange efficiency, the airflow directions in the first heat exchange channel 2a and the second heat exchange channel 2b may be opposite.

For example, as shown in FIGs. 1 to 3, the heat exchanger 2 is provided with an outer air inlet 21, an outer air outlet 22, an inner air inlet 23 and an inner air outlet 24. The outer air inlet 21 and the outer air outlet 22 are in communication with the first heat exchange channel 2a, and the inner air inlet 23 and the inner air outlet 24 are in communication with the second heat exchange channel 2b. The air flows from the external environment into the first heat exchange channel 2a through the outer air inlet 21, and then is discharged to the external environment through the outer air outlet 22. The air in the heat dissipation air duct enters the second heat exchange channel 2b through the inner air inlet 23, and then enters the heat dissipation air duct through the inner air outlet 24.

In order to facilitate the air to flow through the first heat exchange channel 2a, the heat exchanger 2 further includes a third fan 7, which is configured to drive the air from the external environment to flow through the first heat exchange channel 2a.

In the case that the heat exchanger 2 is arranged on the first cabinet door 11, the third fan 7 is arranged on the first cabinet door 11. In the case that the heat exchanger 2 is arranged on the second cabinet door 12, the third fan 7 is arranged on the second cabinet door 12.

In other embodiments, the heat dissipation air duct may also have other structures.

In order to facilitate the formation of the inner circulation air duct, the heat dissipation inlet and the heat dissipation outlet of the heat dissipation air duct, and the heat exchanger 2 may be distributed on the same side of the cabinet body 1. In this case, the inlet and the outlet of the first heat exchange channel 2a may be in communication with the external environment of the cabinet body 1. The heat exchanger 2 further includes the third fan 7, which is configured to drive the air from the external environment to flow through the first heat exchange channel 2a. In this way, it is convenient to form the inner circulation air duct and also convenient to cool the airflow in the inner circulation air duct. The inlet and the outlet of the first heat exchange channel 2a may be in communication with other sources, which is not limited to the above situation.

In the electrical cabinet, the switch 3 generates a large amount of heat and is sensitive to heat. In order to improve the heat dissipation effect of the switch 3, the heat dissipation inlet of the heat dissipation air duct may face the first switch area 16 or the second switch area 19. In this case, the type of the heat exchanger 2 is not limited. For example, the inlet and the outlet of the first heat exchange channel 2a may be both in communication with the external environment of the cabinet body 1, and the heat exchanger 2 further includes the third fan 7 which is configured to drive the air from the external environment to flow through the first heat exchange channel 2a. In this way, the heat dissipation effect of the switch 3 is improved, and it is convenient to cool the airflow in the inner circulation air duct.

It should be noted that, in the case that the heat dissipation inlet is distributed on the first side 13, the heat dissipation inlet faces the first switch area 16; and in the case that the heat dissipation inlet is distributed on the second side 14, the heat dissipation inlet faces the second switch area 19.

The fuse 32 in the switch 3 generates a large amount of heat and is sensitive to heat. In order to improve the heat dissipation effect, the heat dissipation inlet of the heat dissipation air duct may face the fuse 32 in the first switch area 16 or the fuse 32 in the second switch area 19. In practical situations, the heat dissipation inlet of the heat dissipation air duct may face other components, which is not limited in the embodiment.

In some embodiments, the heat dissipation inlet and the heat dissipation outlet of the heat dissipation air duct, and the heat exchanger 2 may be distributed on the same side of the cabinet body 1, and the heat dissipation inlet of the heat dissipation air duct may face the first switch area 16 or the second switch area 19. In this way, it is convenient to form the inner circulation air duct, and the heat dissipation effect of the switch 3 is improved.

In some embodiments, the electrical cabinet further includes a circuit breaker and a power distribution module. Based on this, as shown in FIGs. 3, 5 and 6, the cabinet body 1 is further provided with a circuit breaker area 15 and a power distribution area 18. The circuit breaker area 15 is configured to accommodate the circuit breaker, and the power distribution area 18 is configured to accommodate power distribution module. The circuit breaker area 15 and the first switch area 16 are located on the same side of the cabinet body 1, and the power distribution area 18 and the second switch area 19 are located on the same side of the cabinet body 1.

For example, the circuit breaker area 15 and the first switch area 16 are both located on the first side 13 of the cabinet body 1, and the power distribution area 18 and the second switch area 19 are both located on the second side 14 of the cabinet body 1.

In order to facilitate wiring, the circuit breaker area 15 and the first switch area 16 may be arranged in sequence along the vertical direction, and the power distribution area 18 and the second switch area 19 may be arranged in sequence along the vertical direction.

In an embodiment, the circuit breaker area 15 may be located on the top side of the first switch area 16, and the power distribution area 18 may be located on the top side of the second switch area 19. In another embodiment, the circuit breaker area 15 may be located on the bottom side of the first switch area 16, and the power distribution area 18 may be located on the bottom side of the second switch area 19.

The circuit breaker area 15 and the power distribution area 18 are both located in the heat dissipation air duct. The first switch area 16, the second switch area 19, the circuit breaker area 15, and the power distribution area 18 may be distributed along the airflow direction in the heat dissipation air duct in a predetermined order.

In the case that the heat dissipation air duct includes the first heat dissipation air duct 1a, the second heat dissipation air duct 1b and the third heat dissipation air duct 1c, the circuit breaker area 15 and the power distribution area 18 may be both located in the third heat dissipation air duct 1c. In this case, the first switch area 16, the second switch area 19, the power distribution area 18, and the circuit breaker area 15 may be distributed in sequence along the airflow direction, so that the cold airflow coming from the heat exchanger can firstly flow through the first switch area 16 and the second switch area 19, thereby improving the heat dissipation effect of the switch 3. Alternatively, the circuit breaker area 15, the power distribution area 18, the second switch area 19, and the first switch area 16 are distributed in sequence along the airflow direction, so that the cold airflow coming from the heat exchanger can firstly flow through the circuit breaker area 15 and the power distribution area 18, and then flow through the first switch area 16 and the second switch area 19, thereby improving the heat dissipation effect of components in the circuit breaker area 15 and the power distribution area 18.

As shown in FIGs. 3, 5 and 6, in some embodiments, in order to facilitate wiring, the cabinet body 1 may be further provided with a first wiring area 17 and a second wiring area 110. The first wiring area 17 and the first switch area 16 are located on the same side of the cabinet body 1, and are arranged adjacent to each other. The second wiring area 110 and the second switch area 19 are located on the same side of the cabinet body 1, and are arranged adjacent to each other.

For example, the first wiring area 17 is located at the bottom of the first switch area 16, and the second wiring area 110 is located at the bottom of the second switch area 19.

In the embodiment of the present application, in order to simplify the structure of the electrical cabinet, the circuit breaker area 15 and the power distribution area 18 may be symmetrically distributed, and the first wiring area 17 and the second wiring area 110 may be symmetrically distributed, and the first switch area 16 and the second switch area 19 may be symmetrically distributed.

It should be noted that the above areas do not include devices arranged in the areas.

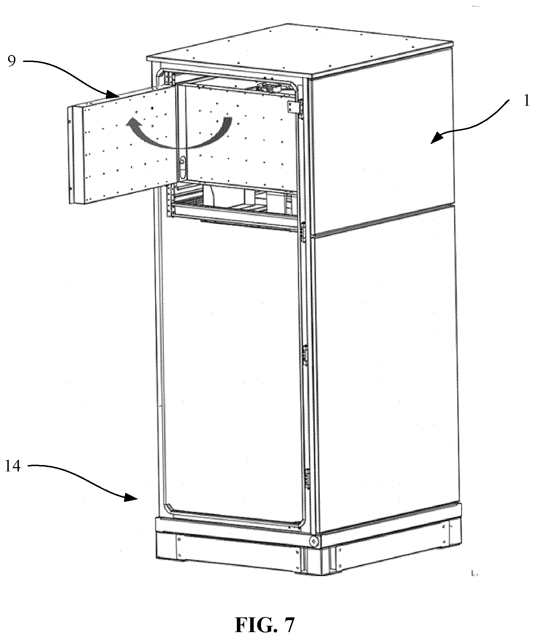

As mentioned above, the cabinet body 1 has the first cabinet door 11 and the second cabinet door 12. As shown in FIG. 7, in some embodiments, a movable tray 9 is provided in the cabinet body 1, and the tray 9 is located on the inner side of at least one of the first cabinet door 11 and the second cabinet door 12.

The tray 9 is configured to mount a first device. When the cabinet door corresponding to the tray 9 is opened, the first device is exposed from the cabinet body 1 to allow the first device to be maintainable. In this way, the maintenance of the first device is convenient, and it is not required to disassemble any structural component, wiring harness and the like, thereby improving the maintainability of the electrical cabinet.

It should be noted that, in a case that the first device does not require maintenance, the cabinet door (the first cabinet door 11 and/or the second cabinet door 12) corresponding to the tray 9 can be closed.

The first device on the tray 9 may include: a counter device and/or a power distribution circuit device. The power distribution circuit device may include a power distribution control panel, a temperature controller, and the like, which is not limited in the embodiment. The first device on the tray 9 may also include other elements, which is not limited in the embodiment.

In order to improve the maintainability of the electrical cabinet, a second device may further be provided in the cabinet body 1, and the second device is located on the inner side of the tray 9. The outer side of the tray 9 faces the cabinet door corresponding to the tray 9, and the inner side of the tray 9 faces away from the cabinet door corresponding to the tray 9. The tray 9 is movably arranged in the cabinet body 1. When the cabinet door corresponding to the tray 9 is opened and the tray 9 is moved to a predetermined position, the second device is exposed from the cabinet body 1 to allow the second device to be maintainable. In this way, the second device can be maintained by opening the corresponding cabinet door and removing the tray 9, without disassembling any structural component, wiring harness and the like, thereby improving the maintainability of the electrical cabinet.

In order to facilitate the maintenance of the second device, the tray 9 may be rotatably arranged in the cabinet body 1. For example, the tray 9 is rotatably arranged in the cabinet body 1 through a hinge.

The tray 9 may be arranged in the cabinet body 1 in such a manner as to be movable along a straight line or in other manners, which is not limited to the above embodiments.

The second device at least includes a fourth fan 8 which is configured to drive the airflow in the heat dissipation air duct to flow through a heating device other than the switch 3. In this way, it is convenient to mount and maintain the fourth fan 8.

In some embodiments, the heating device other than the switch 3 is a circuit breaker. In the case that the circuit breaker area 15 is located in the third heat dissipation air duct 1c, the fourth fan 8 may also be arranged in the third heat dissipation air duct 1c.

The second device may further include at least one of a voltage transformer and a lightning arrester, which is not limited in the embodiment of the present application.

It should be noted that, the tray 9 is configured to mount the first device, and the second device is arranged in the cabinet body 1, which can be carried out simultaneously, thus further improving the maintainability of the electrical cabinet. In an embodiment, mounting the first device on the tray 9 and disposing the second device in the cabinet body 1 can also be carried out separately.

As mentioned above, the heat exchanger 2 may be arranged on the first cabinet door 11 or the second cabinet door 12. For the convenience of installation, one of the tray 9 and the heat exchanger 2 may be arranged on the first cabinet door 11, and the other of the tray 9 and the heat exchanger 2 may be arranged on the second cabinet door 12.

Based on the electrical cabinet according to the above embodiments, a photovoltaic power generation system is also provided according to the present application, which includes the electrical cabinet described above.

The electrical cabinet is connected to an inverter and a transformer. The electric energy of the inverter are combined by the electrical cabinet and transmitted to the transformer.

The electrical cabinet may be a combiner cabinet or of other type, which is not limited in the embodiments of the present application.

Since the electrical cabinet according to the embodiments has the above technical effects, and the photovoltaic power generation system includes the electrical cabinet described above and thus also has corresponding technical effects, which are not repeated herein.

The technical features mentioned above and the technical features shown separately in the drawings may be combined with each other arbitrarily, as long as the combined technical features are not contradictory to each other. All feasible feature combinations are technical contents clearly recorded herein. Any of the multiple sub features contained in the same sentence may be applied independently, and is not necessarily applied together with other sub features.

The above description of the embodiments enables those skilled in the art to implement or use the present application. Various modifications to the embodiments are apparent to those skilled in the art, and the general principles defined herein can be implemented in other embodiments without departing from the spirit or scope of the present application. Therefore, the present application is not limited to the embodiments shown herein, but conforms to the widest scope consistent with the principles and novel features disclosed herein.

## Claims

1. An electrical cabinet, comprising a cabinet body and a heat exchanger; wherein
the cabinet body is provided with a first switch area and a second switch area, the first switch area and the second switch area are distributed on opposite sides of the cabinet body in a first direction, and at least one of the first switch area and the second switch area is provided with a switch; and
the first switch area and the second switch area are both located in a heat dissipation air duct of the cabinet body, and are distributed along an airflow direction in the heat dissipation air duct; and the heat exchanger is configured to exchange heat with the heat dissipation air duct.

2. The electrical cabinet according to claim 1, wherein the heat dissipation air duct is configured to enable airflow to flows through the first switch area and the second switch area in the first direction.

3. The electrical cabinet according to claim 2, wherein the heat exchanger comprises a first heat exchange channel and a second heat exchange channel that are configured for heat exchange, wherein the heat dissipation air duct and the second heat exchange channel are connected end to end to form an inner circulation air duct.

4. The electrical cabinet according to claim 3, wherein the heat dissipation air duct comprises: a first heat dissipation air duct, a second heat dissipation air duct, and a third heat dissipation air duct that are sequentially communicated; wherein
the first heat dissipation air duct and the third heat dissipation air duct are arranged in parallel, and the second heat dissipation air duct and the second heat exchange channel are arranged in parallel;
an inlet of one of the first heat dissipation air duct and the third heat dissipation air duct is a heat dissipation inlet of the heat dissipation air duct, and an outlet of the other of the first heat dissipation air duct and the third heat dissipation air duct is a heat dissipation outlet of the heat dissipation air duct; and
the first switch area and the second switch area are both located in the first heat dissipation air duct.

5. The electrical cabinet according to claim 4, wherein a first cabinet door is provided on a side of the cabinet body having the first switch area, and a second cabinet door is provided on a side of the cabinet body having the second switch area; wherein the second heat dissipation air duct is provided on an inner side of the first cabinet door or the second cabinet door.

6. The electrical cabinet according to claim 4, wherein the first heat dissipation air duct is lower than the third heat dissipation air duct, or the first heat dissipation air duct is higher than the third heat dissipation air duct; and/or
the first heat dissipation air duct is arranged in a horizontal direction, and the third heat dissipation air duct is arranged in the horizontal direction.

7. The electrical cabinet according to claim 4, wherein the heat exchanger, the heat dissipation inlet, and the heat dissipation outlet are distributed on the same side of the cabinet body, and optionally
wherein a first cabinet door is provided on a side of the cabinet body having the first switch area, and a second cabinet door is provided on a side of the cabinet body having the second switch area; wherein the heat exchanger is provided on the first cabinet door or the second cabinet door.

8. The electrical cabinet according to claim 4, wherein
the electrical cabinet further comprises a first fan arranged at a communication position of the first heat dissipation air duct and the second heat dissipation air duct and configured to drive airflow to flow from one of the first heat dissipation air duct and the second heat dissipation air duct to the other of the second heat dissipation air duct and the first heat dissipation air duct; and/or
the heat exchanger further comprises a second fan arranged at a communication position of the third heat dissipation air duct and the second heat exchange channel and configured to drive airflow to flow from one of the third heat dissipation air duct and the second heat exchange channel to the other of the second heat exchange channel and the third heat dissipation air duct.

9. The electrical cabinet according to claim 8, wherein a first cabinet door is provided on a side of the cabinet body having the first switch area, and a second cabinet door is provided on a side of the cabinet body having the second switch area; and
one of the first fan and the second fan is arranged on the first cabinet door, and the other of the first fan and the second fan is arranged on the second cabinet door.

10. The electrical cabinet according to claim 3, wherein
an inlet and an outlet of the first heat exchange channel are both in communication with the external environment of the cabinet; and the heat exchanger further comprises a third fan which is configured to drive air of the external environment to flow through the first heat exchange channel; and/or
a heat dissipation inlet and a heat dissipation outlet of the heat dissipation air duct, and the heat exchanger are arranged on the same side of the cabinet body; and/or
the heat dissipation inlet faces the first switch area or the second switch area.

11. The electrical cabinet according to claim 1, wherein switches in at least one of the first switch area and the second switch area are arranged in a row along a second direction perpendicular to the first direction.

12. The electrical cabinet according to any one of claims 1 to 11, wherein the cabinet body is further provided with a circuit breaker area and a power distribution area, the circuit breaker area and the first switch area are located on the same side of the cabinet body, and the power distribution area and the second switch area are located on the same side of the cabinet body; wherein the circuit breaker area and the power distribution area are both located in the heat dissipation air duct, and optionally
wherein the first switch area, the second switch area, the power distribution area, and the circuit breaker area are sequentially distributed along the airflow direction; or, the circuit breaker area, the power distribution area, the second switch area, and the first switch area are sequentially distributed along the airflow direction.

13. The electrical cabinet according to any one of claims 1 to 11, wherein the cabinet body is further provided with a first wiring area and a second wiring area; the first wiring area and the first switch area are located on the same side of the cabinet body and are adjacent to each other; the second wiring area and the second switch area are located on the same side of the cabinet body and are adjacent to each other.

14. The electrical cabinet according to any one of claims 1 to 11, wherein in a case that a first cabinet door is provided on a side of the cabinet body having the first switch area and that a second cabinet door is provided on a side of the cabinet body having the second switch area, a tray is provided in the cabinet body and is located on an inner side of at least one of the first cabinet door and the second cabinet door; wherein
the tray is configured to mount thereon a first device which is exposed from the cabinet body to enable maintenance of the first device when the cabinet door corresponding to the tray is opened; and/or
a second device is provided in the cabinet body and is located on an inner side of the tray, and the tray is movably arranged in the cabinet body, so that the second device is exposed from the cabinet body to enable maintenance of the second device when the cabinet door corresponding to the tray is opened and the tray is moved to a predetermined position.

15. The electrical cabinet according to claim 14, wherein the tray is rotatably arranged in the cabinet body; and/or
the second device at least comprises a fourth fan which is configured to drive the airflow in the heat dissipation air duct to flow through a heating device other than the switch, e.g., a circuit breaker.

16. A photovoltaic power generation system comprising the electrical cabinet according to any one of claims 1 to 15.
